# EUROPÄISCHE PATENTSCHRIFT

(11) **EP 3 161 463 B1**
(45) Veröffentlichungstag und Bekanntmachung des Hinweises auf die Patenterteilung: **01.12.2021**
(21) Anmeldenummer: 15752911.6
(22) Anmeldetag: 18.06.2015
(51) Int. Cl.: G01N 23/2251, H01J 37/20

(54) **VORRICHTUNG UND VERFAHREN FÜR DIE STÖCHIOMETRISCHE ANALYSE VON PROBEN**
DEVICE AND METHOD FOR THE STOICHIOMETRIC ANALYSIS OF SAMPLES
DISPOSITIF ET PROCÉDÉ POUR L'ANALYSE STOECHIOMÉTRIQUE D'ÉCHANTILLONS

(30) Priorität: 24.06.2014 DE 102014108825
(43) Veröffentlichungstag der Anmeldung: 03.05.2017
(73) Patentinhaber: Leibniz-Institut für Neue Materialien gemeinnützige GmbH, 66123 Saarbrücken (DE)
(72) Erfinder: DE JONGE, Niels, 66386 St. Ingbert (DE); PECKYS, Diana B., 66386 St. Ingbert (DE)
(74) Vertreter: Patentanwälte Gierlich & Pischitzis Partnerschaft mbB
(86) Internationale Anmeldenummer: PCT/DE2015/100245
(87) Internationale Veröffentlichungsnummer: WO 2015/197050

(56) Entgegenhaltungen:
- US-A1- 2011 284 745
- US-A1- 2012 025 103
- US-A1- 2012 120 226
- US-A1- 2012 182 548
- US-A1- 2012 292 505
- DIANA B PECKYS ET AL: "Liquid Scanning Transmission Electron Microscopy: Imaging Protein Complexes in their Native Environment in Whole Eukaryotic Cells", MICROSCOPY AND MICROANALYSIS, SPRINGER, NEW YORK, NY, US, Bd. 20, Nr. 2, 1. April 2014 (2014-04-01), Seiten 346-365, XP001589118, ISSN: 1431-9276, DOI: 10.1017/S1431927614000099 [gefunden am 2014-02-19]
- ELISABETH A RING ET AL: "Microfluidic System for Transmission Electron Microscopy", MICROSCOPY AND MICROANALYSIS, SPRINGER, NEW YORK, NY, US, Bd. 16, Nr. 5, 1. Oktober 2010 (2010-10-01), Seiten 622-629, XP001557276, ISSN: 1431-9276, DOI: 10.1017/S1431927610093669 [gefunden am 2010-08-31]
- NISHIYAMA H ET AL: "Atmospheric scanning electron microscope observes cells and tissues in open medium through silicon nitride film", JOURNAL OF STRUCTURAL BIOLOGY, ACADEMIC PRESS, UNITED STATES, vol. 169, no. 3, 15 January 2010 (2010-01-15), pages 438-449, XP026913027, ISSN: 1047-8477, DOI: 10.1016/J.JSB.2010.01.005

## Beschreibung

Die vorliegende Erfindung betrifft eine Vorrichtung und ein Verfahren für die stöchiometrische Analyse von Proben.

Nach der Dekodierung der DNA des menschlichen Genoms ist eine der nächsten großen Herausforderungen für die Wissenschaft die Funktion von über zehntausend Proteinen, welche die zellulären Funktionen steuern, zu untersuchen und zu verstehen. Viele der wichtigen zellulären Prozesse werden über die dynamische Bildung und Dissoziation von Proteinen in Proteinkomplexen gesteuert. Das Verständnis der Zellfunktion auf der Ebene der Proteine ist daher von entscheidender Bedeutung für die biomedizinische Forschung, beispielsweise in der Forschung, die das Ziel hat, neue Wirkstoffe gegen Erkrankungen wie Krebs und AIDS zu entwickeln. Das Forschungsfeld, welches die Wechselwirkung von Proteinen in Zellen untersucht, ist die Proteomik. Hierbei ist die Untersuchung der Funktionen von Proteinen sehr komplex, weil die Proteine nanoskalige Dimensionen haben und innerhalb einer Zelle in sehr großer Anzahl vorliegen.

Das gegenwärtig vorhandene Wissen wurde bisher zumeist über indirekte biochemische Methoden gewonnen, wie zum Beispiel durch Extraktion bestimmter Proteine aus einer Vielzahl von Zellen, gefolgt von Trennung von Proteinkomplexen, unter Verwendung von zum Beispiel Gelelektrophorese. Durch diese Vorgehensweise erhält man gemittelte Informationen von sehr vielen, typischerweise von mehreren tausenden, Zellen. Jedoch fehlen wichtige Informationen von einzelnen Zellen, kleinen Gruppen von Zellen, oder von bestimmten Bereichen in Zellen. Gerade die Informationen kleiner Populationen sind jedoch wichtig für die Generierung von Wissen bezüglich Zellfunktionen und für die Entwickelung von Medikamenten. Es kann z.B. sein, dass ein bestimmtes Krebsmedikament zwar bei den meisten Krebszellen wirkt, aber nicht bei einer kleinen Population mutierter Krebszellen. Bei dem therapeutischen Einsatz dieses Medikaments kann dann beispielsweise eine kleine Population von Zellen überleben. Es wird daher als sehr wichtig angesehen, neue Verfahren zu entwickeln, die es ermöglichen einzelne Proteine in einzelnen Zellen untersuchen zu können.

Durch die Verwendung von lichtmikroskopischen Methoden können die Bereiche, in denen bestimmte Proteine situiert sind, über spezifische Markierungen visualisiert werden. Beispielsweise werden Fluoreszenz-Tags verwendet, welche durch gentechnische Veränderung von Zellen hergestellt werden, wobei diese beispielsweise das grün fluoreszierende Protein exprimieren, an welches ein spezifisches Protein gekoppelt ist.

Es ist nachteilig, dass die räumliche Auflösung der Lichtmikroskopie beschränkt ist und es daher nicht möglich ist, direkt zu visualisieren, ob bestimmte Proteine einen Komplex bilden oder nicht.

Bestimmte indirekte lichtmikroskopische Techniken, wie Förster-Resonanzenergietransfer (Förster Resonance Energy Transfer, FRET), sind vorhanden und werden verwendet, um Komplexbildung von Proteinen zu detektieren. Jedoch kann man mittels FRET lediglich auf das Vorhandensein von benachbarten Molekülen schließen, nicht diese jedoch räumlich genau auflösen und auch nicht die Bestandteile größerer Proteinkomplexe unterscheiden.

Die Elektronenmikroskopie ist die Methode der Wahl, um nanoskalige Dimensionen zu untersuchen. Jedoch werden für die Abbildung von zellulären Ultrastrukturen mittels herkömmlicher Elektronenmikroskopie dünne Schnitte von Zellen, die in Kunststoffmaterial eingebettet sind oder eingefroren sind, verwendet, wodurch die Zellen nicht intakt bleiben. Dies ist jedoch problematisch für die Erforschung von Membranproteinen, die für viele wichtige Zellfunktionen verantwortlich sind, weil die flächige Zellmembran beim Schneiden durchtrennt wird und danach nur als zweidimensionale Linienstruktur zu untersuchen ist. Nachteilig ist auch, dass die Untersuchung von Dünnschnitten sehr zeitaufwendig ist. Beispielsweise würde die Untersuchung einer ganzen Zelle, die in einer Vielzahl von Dünnschnitten vorliegt, mehrere Wochen Arbeit in Anspruch nehmen.

US 2012/0120226 A1 beschreibt eine Messkammer zur Durchführung von STEM Messungen an Zellen durchzuführen. Die Vorrichtung kann auch ein Lichtmikroskop umfassen.

H. Nishiyama et al. Journal of Structural Biology 2010 (169), 438-449 Athmospheric scanning electron microscope observes cells and tissues in open medium through silicon nitride film beschreibt SEM und Lichtmikroskopie unter atmosphärischen Bedingungen, wobei die reflektierten Elektronen detektiert werden. Das Lichtmikroskop ist nicht modifiziert.

US 2011/0284745 A1 beschreibt eine Probenhalterung fiir SEM zur Beobachtung von lebenden Zellen mit SEM und Lichtmikroskopie, wobei die reflektierten Elektronen detektiert werden. Die Probe kann dabei unter atmosphärischen Bedingungen gehalten werden. Das Lichtmikroskop ist nicht modifiziert.

Es ist daher die Aufgabe der Erfindung, eine Vorrichtung und ein Verfahren für die Proteomik bereitzustellen, die es ermöglichen, die räumliche Verteilung von verschiedenen

Proteinen in kompletten und einzeln untersuchbaren Zellen innerhalb eines kürzeren Zeitraums zu untersuchen.

Die Aufgabe wird durch eine Vorrichtung für die stöchiometrische Analyse von Proben gelöst, wobei die Vorrichtung
- a) eine Probenverarbeitungsvorrichtung, umfassend eine Probenhalterung zum Halten der Probe, Mittel zum Einstellen der Temperatur, Mittel zum Hinzufügen und Entfernen von Fluiden sowie mindestens ein Fluidreservoir,
- b) ein Elektronenmikroskop mit einem STEM Detektor und ein Lichtmikroskop, sowie
- c) eine durch einen Computer gesteuerte Prozesssteuerungseinrichtung zum Steuern der Mittel zum Einstellen der Temperatur und der Mittel zum Hinzufügen und Entfernen von Fluiden sowie eine durch einen Computer gesteuerte und automatisierte Bildaufnahmevorrichtung, welche mittels des Elektronenmikroskops oder Lichtmikroskops Bilder aufnimmt, eine die aufgenommenen Bilder speichernde Einheit, sowie eine durch den Computer gesteuerte Bildanalyseeinheit umfasst, wobei das Lichtmikroskop eine lichtoptische Linse, die einen Hohlraum aufweist, umfasst.

Fluide umfassen hierbei sowohl Gase, als auch Flüssigkeiten.

Die Probenverarbeitungseinrichtung bzw. Zellenverarbeitungseinrichtung besteht aus verschiedenen Komponenten. Es ist vorgesehen, dass die Probe in einer Kavität (Vertiefung) einer Messplatte immobilisiert vorliegt. Die Probe ist dabei vorzugsweise auf einer Probenhalterung immobilisiert. Die Probenhalterung kann eine Membran sein. Mittels eines Mittels zum Hinzufügen von Fluiden, beispielsweise einer Pipettenspitze, das über einen flexiblen Schlauch mit einer Fluid-Mischkammer verbunden ist, können verschiedene Fluide (Flüssigkeiten und/oder Gase) aus dem mindestens einen Fluidreservoir der Probe, die in einer Kavität angeordnet sein kann, zugeführt werden. Es ist vorgesehen, dass das Mittel zum Hinzufügen von Fluiden mit einem Manipulator für die drei Dimensionen x, y, z verbunden ist, so dass das Mittel zum Hinzufügen von Fluiden Fluide in alle Kavitäten einbringen kann. Das Fluid kann mittels einer Spritze oder einer Pumpvorrichtung aus dem mindestens einen Fluidreservoir der Fluid-Mischkammer und daraufhin der mindestens einen Probe zugeführt werden. Es ist vorgesehen, dass mehrere Fluidreservoirs, die unterschiedliche Volumina und unterschiedliche Fluide beinhalten, verfügbar sind. Die Flüssigkeit, die beispielsweise ein Puffer, ein Zellkulturmedium oder Vergleichbares sein kann, kann (nach vorbestimmter Zeit) mittels eines Mittels zum Entfernen von Fluiden, welches über einen flexiblen Schlauch mit einem Behälter oder einer weiteren Messeinrichtung, wie beispielsweise eine Anlage zur chemischen Analyse, verbunden ist, über beispielsweise eine weitere Pumpeinrichtung entfernt werden. Es ist ebenfalls vorgesehen, dass das Mittel zum Entfernen von Fluiden mit einem weiteren Manipulator für die drei Dimensionen x, y, z verbunden ist, so dass das Mittel zum Entfernen von Fluiden Fluide von allen Proben entfernen kann, wobei die Proben in Kavitäten angeordnet sein können.

Sobald die Probenvorbereitung mittels der Probenverarbeitungseinrichtung abgeschlossen ist, oder auch während der Probenvorbereitung, können hochaufgelöste Bilder mittels eines Elektronenmikroskops aufgenommen werden. Dazu werden Probenhalterung und Elektronenmikroskop zueinander positioniert.

Es ist hierbei vorstellbar, dass die Bilder durch eine Vorrichtung für die korrelative Raster-Transmissionselektronenmikroskopie und Lichtmikroskopie aufgenommen werden.

Der dritte Teil der Vorrichtung für die stöchiometrische Analyse von Proben umfasst eine Computer- und Treibereinheit, die sowohl elektrische als auch mechanische Komponenten umfasst. Der Computer steuert die Probenverarbeitung in einer automatisierten Weise. Wenn die Proben prozessiert sind, stellt der Computer die Einstellungen von Probenbearbeitung auf Durchführung der Elektronenmikroskopie um und zeichnet die elektronenmikroskopischen Aufnahmen auf. Eine automatisierte Software sorgt dafür, dass die gewünschten Bereiche der Proben abgebildet werden, so dass Informationen von den Markierungen der Proben erhalten werden. Es ist ebenfalls vorgesehen, dass der Computer auch eine Software für die automatisierte Datenanalyse enthält, so dass die relevanten Informationen über die Proben automatisch erhalten werden.

Es ist erfindungsgemäß vorgesehen, dass die Probenhalterung in einer Kavität angeordnet ist.

Es ist hierbei vorstellbar, dass die Probenhalterung am Boden der Kavität angeordnet ist oder durch Abstandshalter, die unterhalb der Probenhalterung angeordnet sind, in der Kavität über dem Boden der Kavität beabstandet angeordnet ist.

Es ist im Rahmen der Erfindung ebenfalls vorgesehen, dass die Probenhalterung als dünne elektronendurchlässige Membran ausgebildet ist. Dies ist für die Untersuchungen mit dem Elektronenmikroskop von Vorteil.

Weiterhin ist erfindungsgemäß vorgesehen, dass die Proben in einer Flüssigkeit auf der Probenhalterung aufgebracht und mit einem Deckel, der ein elektronendurchlässiges Fenster umfasst, abgedeckt sind.

Es ist zu der Erfindung gehörig, dass die Probenverarbeitungsvorrichtung einen dreidimensional beweglichen Objekttisch aufweist.

Eine Ausgestaltung der Erfindung sieht vor, die Proben mittels eines Rasterelektronenmikroskops (scanning electron microscope SEM) zu untersuchen.

Eine weitere Ausgestaltung der Erfindung sieht vor, die Proben mittels eines Transmissionselektronenmikroskops (TEM) zu untersuchen.

Es ist weiterhin zu der Erfindung gehörig, dass die Aufnahmen von Elektronenmikroskopbildern mittels einer Vorrichtung für die Raster-Transmissionselektronenmikroskopie (scanning transmission electron microscope, STEM) durchgeführt werden, wobei ein STEM-Detektor mit Empfindlichkeit für Atom-Zahl, ein sogenannter Z-Kontrast, eingesetzt wird. Der STEM-Detektor sorgt dafür, dass die Marker im Gegensatz zu dem umliegenden Zellmaterial einen höheren Kontrast liefern. Dieser Detektor kann entweder im SEM oder im TEM montiert sein.

Es ist zu der Erfindung gehörig, dass ein Vakuum in der Kavität einstellbar ist.

Es ist weiterhin zu der Erfindung gehörig, dass die Proben getrocknet werden und in Vakuum gebracht werden, damit elektronenmikroskopische Untersuchungen durchgeführt werden können.

Es ist weiterhin zu der Erfindung gehörig, dass die Proben auf einige Grad Celsius abgekühlt und in ein geringes Vakuum von etwa 10 mbar gebracht werden. Dabei wird das Vakuum so genau eingestellt, dass zuerst die überstehende Flüssigkeit verdampft und danach eine dünne Flüssigkeitsschicht, deren Dicke im Nanometerbereich liegt, über der Probe erhalten bleibt, damit z.B. Zellen in Flüssigkeit untersucht werden können.

Es ist weiterhin zu der Erfindung gehörig, dass die Proben direkt in Flüssigkeit mittels Elektronenmikroskopie untersucht werden, wobei das Vakuum im Elektronenmikroskop durch eine dünne Membran von der Probenkammer getrennt wird. Die Dicke der dünnen Membran liegt im Nanometerbereich.

Dier Erfindung sieht vor, die Proben zudem mittels eines Lichtmikroskops, zum Beispiel eines Fluoreszenzmikroskops, zu untersuchen. Dabei sind die beiden Mikroskope in einem Gerät integriert.

Eine Ausgestaltung der Erfindung sieht vor, dass die Probenhalterung Markierungen enthält, die sowohl in einem Lichtmikroskopiebild, als auch in einem Elektronenmikroskopiebild zu erkennen sind. Diese Ausgestaltung ist sinnvoll damit die Ortsinformationen der beiden Mikroskopieverfahren korreliert werden können. Die Markierung kann z.B. eine Kante von Silizium sein, die mit etwa 100 nm Genauigkeit hergestellt ist.

Die Vorrichtung umfasst ein Lichtmikroskop, wobei das Lichtmikroskop eine lichtoptische Linse, die einen Hohlraum aufweist, umfasst.

Es ist hierbei vorgesehen, dass die Detektionsvorrichtung die effiziente Detektion mittels STEM-Mikroskopie von Materialien mit hoher Atomzahl, beispielsweise spezifischen Nanopartikel-Markern in einer Probe in einer Flüssigkeit, wie einer Zelle, mit gleichzeitiger Lichtmikroskopie, beispielsweise über Fluoreszenzkontrast an fluoreszierenden Proteinmarkern in Zellen oder über Streukontrast des Zellmaterials, kombiniert. Durch die Verwendung einer solchen Vorrichtung werden eine höchst effiziente Detektion von Materialien mit hoher Atomzahl in der Probe mit größtmöglicher Auflösung und eine vollständige zeitkorrelative Lichtmikroskopie ermöglicht. Zum Beispiel können die genauen Positionen der z.B. mit "QuantumDot" (QD)-markierten-Proteine mit dem Vorkommen von Fluoreszenz der QD-Typ entsprechenden Wellenlängen in fluoreszenzmikroskopischen Bildern verglichen werden. Anhand dieser Information kann in Erfahrung gebracht werden, in welchen Zellen oder zellulären Regionen ein bestimmtes Protein vorkommt.

Weiterhin ist es hierbei vorteilhaft, dass in dem Hohlraum der lichtoptischen Linse der STEM-Detektor des Elektronenmikroskops angeordnet ist.

Weiterhin ist hierbei als vorteilhafte Ausgestaltung vorgesehen, dass der Hohlraum probenseitig eine Öffnung mit geringem Durchmesser aufweist, an die sich ein Elektronendriftraum anschließt, an dessen unteren Ende der STEM-Detektor angeordnet ist.

Unten bezieht sich hierbei auf eine Elektronenstrahlrichtung von oben nach unten. Beliebige Strahlenrichtungen sind möglich, abhängig von der Anordnung der Vorrichtung. Dies bedeutet, dass auf der der Probenhalterung zugewandten Seite der Linse die Öffnung angeordnet ist, an die sich ein (konisch) nach unten erweiternder Elektronendriftraum anschließt, an dessen unteren Ende der STEM-Detektor des Rastertransmissionselektronenmikroskops angeordnet ist.

Das Signal des STEM-Detektors kann auf der Seite der Linse nach außen ausführbar sein.

Ebenfalls ist es zu der Erfindung gehörig, dass ein Vakuum in dem Elektronendriftraum einstellbar ist.

Für die Aufnahmen von Elektronenmikroskopbildern, die mittels einer Vorrichtung für die korrelative Raster-Transmissionselektronenmikroskopie und Lichtmikroskopie durchgeführt werden, kann weiterhin vorgesehen sein, dass eine Elektronenstrahlquelle auf der dem STEM-Detektor gegenüberliegenden Seite der der Probenhalterung angeordnet ist.

Die Detektionsvorrichtung kann auch eine Linse aufweisen, wobei eine Lichtquelle und lichtoptische Detektionsmittel mit der Linse verbunden sind.

Die Linse mit integriertem STEM-Detektor kann in unterschiedliche Elektronenmikroskope eingebaut werden, z.B. in ein Environmental Scanning Electron Microscope (ESEM) mit einer typischen Elektronenenergie von 10 bis 30 keV oder in ein hochauflösendes STEM mit einer typischen Elektronenenergie von 200 keV.

Es ist vorteilhaft, wenn die Detektionsvorrichtung für die korrelative Raster-Transmissionselektronenmikroskopie und Lichtmikroskopie einen oder mehrere andere lichtoptische Strahlengänge zur Detektion oder zur Beleuchtung aufweist.

Für die Aufnahmen von Elektronenmikroskopbildern, die mittels einer Vorrichtung für die korrelative Raster-Transmissionselektronenmikroskopie und Lichtmikroskopie durchgeführt werden, ist es ebenfalls möglich, dass die Lichtquelle seitlich des STEM-Detektors angeordnet ist, der Lichtstrahl sich im Fokus mit dem Elektronenstahl überlappt und der lichtoptische Detektionsweg sich mit dem Beleuchtungsstrahl überlappt.

Man könnte jedoch auch für die Aufnahmen von Elektronenmikroskopbildern, die mittels einer Vorrichtung für die korrelative Raster-Transmissionselektronenmikroskopie und Lichtmikroskopie durchgeführt werden, eine Vorrichtung verwenden, bei der der STEM-Detektor zwischen der optischen Linse und der Probe angeordnet ist. In gleicher Weise ist es möglich, dass der STEM-Detektor in den Bereich zwischen der optischen Linse und der Probe verfahrbar ist.

Es ist auch vorgesehen, dass ein weiterer Detektor verwendet wird, z.B. ein Sekundärelektrondetektor oder einen Rückstreudetektor. Es ist ebenfalls vorstellbar, dass Röntgensignale detektiert werden können.

Weiterhin ist vorgesehen, dass die Proben biologische Zellen, bevorzugt eukaryotische Zellen, sind.

Es ist jedoch ebenso vorstellbar, dass die Proben biologische Moleküle, Nanopartikel, Polymere, keramische oder metallische Mikrostrukturen sind.

Es ist vorteilhaft, dass die dünne elektronendurchlässige Membran durch einen Mikrochip und/oder ein Gitter gestützt ist.

Hierbei ist es zu der Erfindung gehörig, dass die dünne elektronendurchlässige Membran aus Siliziumnitrid oder Siliziumoxid besteht oder mit Kohlenstoff beschichtet ist.

Die Aufgabe der Erfindung wird ebenfalls durch ein Verfahren für die stöchiometrische Analyse von Proben gemäß dem Anspruch 16 unter Verwendung einer Vorrichtung gemäß Anspruch 1 gelöst.

Es ist im Rahmen der Erfindung für das Verfahren vorgesehen, dass als Elektronenmikroskop ein Rasterelektronenmikroskop (SEM), ein Transmissionselektronenmikroskop (TEM) oder ein Rastertransmissionselektronenmikroskop (STEM) verwendet. Hierbei ist weiterhin im Rahmen der Erfindung vorgesehen, dass ein STEM-Detektor benutzt wird.

Es ist ebenfalls vorstellbar, dass neben dem Elektronenmikroskop ein Lichtmikroskop zur Aufnahme von Lichtmikroskopiebildern verwendet wird. Die Lichtmikroskopiebilder können zusätzlich zu jedem gewünschten Zeitpunkt nach der Probenverarbeitung aufgenommen werden.

Das Verfahren ist nachfolgend beispielhaft für Zellen als Proben erläutert. Selbstverständlich können aber auch andere Proben mittels des Verfahrens vermessen werden.

Die Zellen werden zuerst auf der Trägermembran, in einer flüssigen Umgebung, die Zellen am Leben erhält, zum Anhaften gebracht. Anschließend werden die Zellen mit spezifischen Markern für eine ausgewählte Gruppe von Proteinen inkubiert. Beispielsweise kann ein Protein in der Zellmembran einer eukaryotischen Zelle markiert werden. Die Markierungen können aus Nanopartikeln, z. B. Gold -Nanopartikel, aber auch Nanopartikeln aus anderen Materialien, bestehen. Wenn verschiedene Nanopartikelmaterialien verwendet werden, unterscheiden sich diese in ihren Elektronendichten. Zudem können die Nanopartikel auch unterschiedliche Formen, wie kugelförmig, ellipsenförmig, stäbchenförmig oder würfelförmig aufweisen. Es ist ebenfalls vorstellbar, dass fluoreszierende Nanopartikel verwendet werden. Der Linker (Verbinder) zwischen dem Protein und dem Nanopartikel kann beispielsweise aus einem Protein-Linker, beispielsweise Streptavidin-Biotin, oder aus einem kurzen auf Kohlenstoff basierenden Molekül bestehen, wie einem Lipid. Es ist vorgesehen, dass der Linker auf der dem Nanopartikel gegenüberliegenden Seite eine Bindungsstelle für das Protein aufweist. Weiterhin sollten die Linker ausreichend klein, etwa im Bereich von 5-10 Nanometer, sein, so dass die spezifischen Bindungen von mehreren Markern an den verschiedenen Bestandteilen eines Proteinkomplexes möglich ist. Beispielsweise kann ein Antikörperfragment verwendet werden. Eine weitere Möglichkeit besteht darin, einen Liganden für ein Rezeptorprotein zu verwenden, wenn ein bestimmter Rezeptor untersucht werden soll. Es kann auch ein anderes kleines chemisches Molekül, welche aus einer kurzen Peptidsequenz, die aus höchstens 60 Aminosäuren besteht oder einer kurzen RNA oder DNA-Sequenz, die aus höchstens 70 Nukleotiden besteht, zum spezifischen Binden an ein Protein eingesetzt werden.

Eine mögliche Verwendung der spezifischen Proteinmarkierung könnte beispielsweise die Verwendung der Markierung zur Detektion des HER2-Proteins, neuer Krebsmedikamente sowie als möglicher Kandidat für die Diagnose von Krebs liegen. HER2 ist insbesondere von Bedeutung für Brustkrebs, da es bei ca. einem Drittel aller bösartigen Brusttumoren überexprimiert ist und dies signifikant mit einer erniedrigten Überlebensdauer korreliert. Hierbei kann ein Peptid verwendet werden, welches spezifisch an HER2 binden kann und das verwandt ist mit der Domain des staphylococcal Protein A (SPA), welches ungefähr 1-13 Substitutionsmutationen aufweist.

Eine weitere Möglichkeit besteht darin, eine Streptavidin-Bindungsregion in das Zielprotein zu klonen. Andere äquivalente Möglichkeiten bestehen natürlich ebenfalls und sind zu der Erfindung gehörig. Die Inkubation mit den Markierungen kann parallel oder sequentiell erfolgen. Es ist ebenfalls im Rahmen der Erfindung vorgesehen, dass zuerst die Liganden oder Antikörper an das Protein binden, gefolgt von der daraufhin hinzugefügten Markierung, die Nanopartikel beinhaltet. Die Zellen können fixiert werden, beispielsweise mit Glutaraldehyd. Es ist jedoch auch vorstellbar, dass die Zellen nicht fixiert werden.

Es ist ebenfalls vorstellbar, dass ein Marker für spezifische Proteinmarkierungen zwei Einheiten umfasst, wobei die erste Einheit ein kleines Molekül zum spezifischen Binden an ein Protein sowie mindestens ein chemisch gekoppeltes Molekül zum Anbinden an die zweite Einheit umfasst und die zweite Einheit ein oberflächenmodifiziertes Nanopartikel umfasst, wobei das oberflächenmodifizierte Nanopartikel eine Oberflächenbeschichtung aufweist, welche zumindest ein Molekül zum Anbinden an die erste Einheit umfasst.

In dem nächsten Schritt des Verfahrens werden die Zellen mittels Elektronenmikroskopie untersucht. Mittels des Elektronenmikroskops werden Bilder/Daten über die Standorte der spezifischen Markierungen in einer bestimmten Region der Zelle generiert, welche in einem Speicherort abgespeichert werden. Die Durchführung der Elektronenmikroskopie ist bekannt und wird hier nicht weiter erläutert. Es ist ebenfalls vorgesehen, dass Daten bzw. Bilder von einer Vielzahl von Regionen von mehreren Zellen aufgezeichnet werden. Die Informationen über die Standorte und Größen von diesen Regionen werden daraufhin gespeichert. Vorzugsweise ist vorgesehen, dass die Elektronenmikroskopie in einer vollständig automatisierten Weise durchgeführt wird. Im Falle, dass die Art der Probe immer ähnlich ist, kann ein Standard-Verfahren programmiert werden.

Das Elektronenmikroskop liefert zweidimensionale Bilder. Optional können dreidimensionale Informationen, durch zum Beispiel Aufnahmen von Bildern für verschiedene Neigungswinkel der Probe, erhalten werden.

Es ist ebenfalls vorgesehen, dass ein Lichtmikroskop Bilder aufzeichnet, wodurch Übersichtsbilder von Zellen erstellt werden, die die Lebensfähigkeit der Zellen wiedergeben, oder um zelluläre Regionen mit fluoreszierenden Markierungen zu visualisieren. Aus diesen Informationen kann zum Beispiel in Erfahrung gebracht werden, in welchen Zellen oder zellulären Regionen und in welchem jeweiligem Ausmaß dort ein bestimmtes Protein vorkommt. Damit können Populationen, die unterschiedliche Expressionen eines Proteins aufweisen, selektiert und ausgewählt werden.

Zudem kann mittels Licht- und/oder Fluoreszenzmikroskopie eine lebende Zelle zeitaufgelöst untersucht werden. Zelluläre Prozesse können damit auch dynamisch erforscht werden. Sobald sich ein bestimmter Prozess in einem konkreten Stadium befindet, kann eine bestimmte Phase der Markierung oder Fixierung initiiert werden, damit die Markerinformation zeitlich mit einem zellulären Prozess korreliert ist. Auch kann damit der genaue Zeitpunkt der Markierung nach Zugabe eines Wirkstoffes, wie z.B. einem krebshemmenden Medikament, bestimmt werden.

Es ist erfindungsgemäß vorgesehen, dass während des Verfahrens eine automatisierte Analyse der Markierungspositionen vorgenommen wird. Dabei können die Positionen der Markierungen mit Hilfe einer geeigneten Software automatisch bestimmt werden.

Es ist ebenfalls vorgesehen, dass die Software zunächst die Bilder bzw. Daten von Rauschen- und Hintergrundvariationen filtert, woraufhin ein Schwellenwert festgelegt wird, und die Pixel, die den Schwellenwert passieren, darauf untersucht werden, welcher Signalpegel und welche Form zu welchem Nanopartikel gehört.

Die Bilder werden daraufhin auf das Vorhandensein verschiedener Nanopartikel analysiert. Die Software diskriminiert die verschiedenen Formen und Signalpegel und entscheidet, ob die Pixel eine bestimmte Markierung wiedergeben. Es ist ebenfalls im Rahmen der Erfindung vorgesehen, dass die Software Markierungen, die aus verschiedenen Größen bestehen, erfassen kann. Verschiedene Formen der Markierungen können ebenfalls erfasst werden, beispielsweise Kugelform, Ellipsen-Form bzw. Stäbchen-Form oder Würfelform. Ebenfalls können Markierungen mit unterschiedlicher Elektronendichte erfasst und unterschieden werden, da diese unterschiedliche Signalpegel aufweisen. Sobald eine Markierung eines bestimmten Typs erfasst wird, wird dessen mittlere Pixelposition ermittelt und gespeichert.

Dieser Datenanalyseprozess kann für zweidimensionale Bilder sowie für dreidimensionale Bilder angewendet werden. Auf diese Weise kann eine Datenbank mit Informationen über Markierungstyp und Lage, wobei verschiedene Markierungstypen verschiedene Proteine wiedergeben, erstellt werden. Diese Datenbank enthält auch Informationen über den Ort und die Größe der Region, in der das Bild aufgenommen wurde.

Als nächstes werden die gesammelten Informationen sortiert und teilweise überlappende Bereiche von Bildern entfernt. Die Analyse wird für alle gewünschten Bereiche der Zellen in einer Kavität durchgeführt. Falls erforderlich, können die Daten von anderen Kavitäten ebenfalls analysiert werden.

Die resultierende Datenbank enthält Informationen über die Orte der ausgewählten Gruppe von Proteinen in einem ausgewählten Satz von zellulären Regionen sowie für einen ausgewählten Satz von Zellen.

Eine Ausgestaltung der Erfindung sieht vor, dass im Schritt b) des Verfahrens spezifische Markierungen, insbesondere Nanopartikel, die spezifisch an Proteinen anbinden, der Probe zugeführt werden. Es können auch fluoreszierende Marker eingesetzt werden.

Bei der Untersuchung von zwei oder mehr verschiedenen Proteinspezies können diese mit unterschiedlichen und unterscheidbaren Markierungen markiert werden. Beispielsweise können verschiedene Arten der Familie "epidermal growth factor receptor" (EGFR) parallel detektiert werden. Beispiele von Markierungen umfassen Nanopartikel unterschiedlicher Größe (im Handel erhältlich sind u.a. Nanopartikel mit 1.4, 5, 10 oder 20 nm Durchmesser), oder Formen, wie beispielsweise Kugel, Ellipsoid, Stab, Würfel, etc.. Es können auch Nanopartikel aus verschiedenen Materialien verwendet werden, z.B. Au-Nanopartikel, PbSe, CdSe/ZnS-Nanopartikel oder Pt-Nanopartikeln. Insbesondere CdSe/ZnS-Nanopartikel sind vorteilhaft für die Untersuchung der Zellen mit korrelativer Fluoreszenzmikroskopie und Elektronenmikroskopie. Aber auch Ni- oder Fe-Nanopartikel können in Kombination mit bildgebenden Verfahren verwendet werden.

Die Vorrichtung und das Verfahren dieser Erfindung sind nicht auf die Untersuchung von markierten Proteinen in Zellen beschränkt, sondern können auch für verschiedene andere Anwendungen verwendet werden. Jede andere Probe, für welche automatisierte chemische Verarbeitung und Elektronenmikroskopie erforderlich ist, kann untersucht werden. Beispiele für die Anwendung der erfindungsgemäßen Vorrichtung und des Verfahrens sind Experimente, bei denen Bakterien oder biologische Verbindungen, wie beispielsweise Protein-Komplexe, DNA oder Viren, unterschiedlichen chemischen Bedingungen ausgesetzt werden. Ebenfalls kann Proteinkristallisation mittels der Vorrichtung und des Verfahrens in einer Reihe von Experimenten schnell untersucht werden. Auch kann die Selbstassemblierung von Nanopartikeln mit bestimmten Beschichtungen als Funktion der Eigenschaften der umgebenden Flüssigkeit oder die von Polymeren gebildeten Mikrostrukturen bei unterschiedlichen chemischen Bedingungen untersucht werden. Es ist ebenfalls vorstellbar, dass Metallstücke untersucht werden, beispielsweise kann Stahlkorrosionsbildung unter unterschiedlichen Bedingungen getestet werden. Es ist auch möglich, Biopsie-Material mit geringer Dicke zu analysieren. Verschiedene andere Materialien können ebenfalls untersucht werden.

Nachfolgend wird die Erfindung anhand von Zeichnungen erläutert.

Es zeigen
- Fig. 1: eine schematische Darstellung der Komponenten der Vorrichtung für die stöchiometrische Analyse von Proben,
- Fig. 2: eine schematische Darstellung der Detektionsvorrichtung für die korrelative Raster-Transmissionselektronenmikroskopie und Lichtmikroskopie,
- Fig. 3: eine schematische Darstellung einer zellulären Plasmamembran.

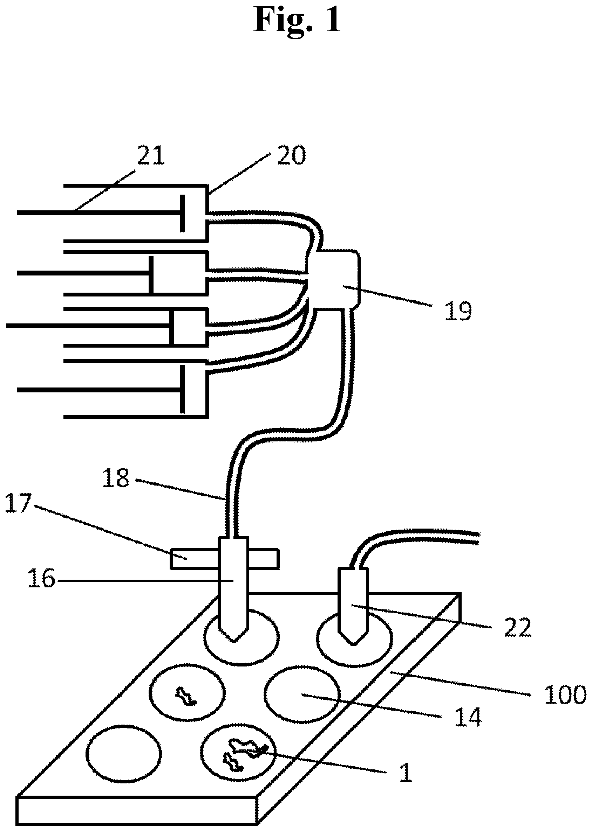

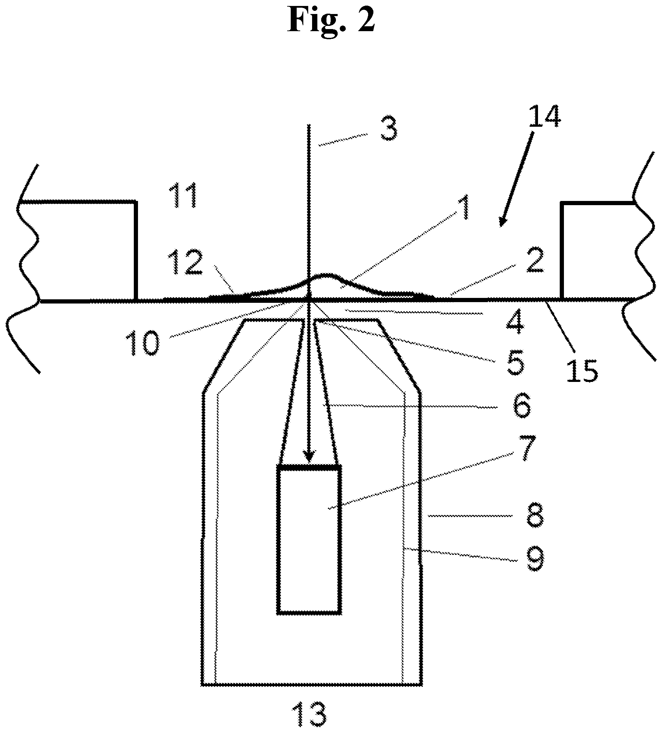

Figur 1 zeigt eine schematische Darstellung einiger der möglichen zu verwendenden Komponenten einer Zellenverarbeitungseinrichtung. Es ist vorgesehen, dass sich die Zellen (1) in einer Flüssigkeit befinden können, wobei die Zellen (1) vorzugsweise in einer Kavität (Vertiefung) (14) einer für Zellkultur geeignete Platte (100) immobilisiert sind. Die Zellen sind dabei vorzugsweise auf einer Probenhalterung (15) immobilisiert (siehe hierfür auch Fig. 2). Die Probenhalterung kann eine Membran sein. In der Fig. 1 ist eine 6-Kavitäten-Zellkulturplatte (100) dargestellt. Es ist jedoch auch vorstellbar, dass die Zellen in 24-Kavitäten-, 96-Kavitätenplatten oder jedem anderen gängigen Zellkulturformat kultiviert werden. Beispielsweise sind die Zellen (1) am Boden der Kavität (14) adhäriert. Mittels einer Pipettenspitze (16), die über einen flexiblen Schlauch (18) mit einer Fluid-Mischkammer (19) verbunden ist, können verschiedene Fluide (Flüssigkeiten und/oder Gase) aus dem mindestens einen Fluidreservoir (20) in die Kavität überführt werden. Die Pipettenspitze (16) ist mit einem Manipulator (17) für die drei Dimensionen x, y, z verbunden, so dass die Pipettenspitze (16) Fluide in alle Kavitäten (Vertiefungen) einbringen kann. Das Fluid kann mittels einer Spritze oder einer Pumpvorrichtung (21) aus dem mindestens einen Fluidreservoir (20) der Fluid-Mischkammer (19) und daraufhin der mindestens einen Kavität (14) zugeführt werden. Es ist vorgesehen, dass mehrere Fluidreservoirs (20), die unterschiedliche Volumina und unterschiedliche Fluide beinhalten, verfügbar sind. Die Flüssigkeit, die beispielsweise ein Puffer, ein Zellkulturmedium oder Vergleichbares sein kann, kann (nach vorbestimmter Zeit) mittels einer zweiten Pipettenspitze (22), die über einen flexiblen Schlauch (18) mit einem Behälter oder einer weiteren Messeinrichtung, wie beispielsweise eine HPLC-Anlage, verbunden ist, über beispielsweise eine weitere Pumpeinrichtung entfernt werden. Es ist ebenfalls vorgesehen, dass die zweite Pipettenspitze (22) mit einem weiteren Manipulator für die drei Dimensionen x, y, z verbunden ist, so dass die zweite Pipettenspitze (22) Fluide aus allen Kavitäten (Vertiefungen) entfernen kann.

Fig. 2 zeigt eine Detektionsvorrichtung für die korrelative Raster-Transmissionselektronenmikroskopie und Lichtmikroskopie. Eine Probe (1), beispielsweise eine eukaryotische Zelle (1), ist in einer Kavität (14) auf einer Probenhalterung (15), beispielsweise einer dünnen elektronendurchlässigen Membran (2), angeordnet. Die Membran (2) ist mit der Probenhalterung (15) verbunden. Die Probe (1) wird mit einem Elektronenstrahl (3) abgebildet, wobei typischerweise die Probe (1) mit einem Elektronenstrahl (3) abgescannt wird. Übertragene Elektronen propagieren durch die Membran (2) über einen Spalt (4) in einen Hohlraum mit kleiner Öffnung (5) in einen Elektronendriftraum (6) zum STEM-Detektor (7). Der Elektronendriftraum (6) und der STEM-Detektor (7) sind in einem Hohlraum in der lichtoptischen Linse (8) angeordnet. Die Linse (8) fokussiert einen breiten Lichtstrahl (9) in einem Fokalpunkt (10) auf die Probe (1). Die Probe (1) und der Elektronendriftraum (6) befinden sich im Vakuum (11). Eine dünne Flüssigkeitsschicht (12) wird über der Probe (1) aufrechterhalten. Die lichtoptische Detektion und die Lichtquelle sind in dem Bereich (13) unter der Linse (8) angeordnet.

Die erfindungsgemäße Vorgehensweise ist wie folgt.

Eine Probe (1) in einer Flüssigkeit, beispielsweise eine eukaryotische Zelle, ist auf einer dünnen Membran (2) angeordnet. Die Membran (2) besteht aus leichten Materialien mit geringer Atomzahl, beispielsweise Kohlenstoff, Siliziumoxid oder Siliziumnitrid, so dass ein Elektronenstrahl (3) mit ausreichender Energie, beispielsweise 30 keV oder 200 keV, die Membran (2) durchdringen kann.

Die Membran (2) wird von einem Träger, z.B. einem Siliziummikrochip oder einem dünnen Material, getragen. Der Träger ist auf einer Probenhalterung mit Mitteln zum Bewegen in x, y und z-Richtung angeordnet. Der Elektronenstrahl (3) ist so konfiguriert, dass die Strahlrichtung von der Oberseite zu der Unterseite des Mikroskops und durch die Probe (1) verläuft. Selbstverständlich kann der Elektronenstrahl statt von oben nach unten auch in einer anderen Richtung verlaufen, beispielsweise von unten nach oben oder von links nach rechts.

Eine spezielle optische Linse (8) ist unter der Membran (2) angeordnet. Der Strahlengang ist so angeordnet, dass das Licht durch die Linse (8) tritt und auf die Probe fokussiert wird, während reflektiertes oder fluoreszierendes Licht mit der gleichen Linse (8) gesammelt und zum Detektor geleitet wird, beispielsweise unter Verwendung eines optischen Filterwürfels, der aus zweifarbigen Spiegeln besteht. Der Lichtstrahl konvergiert in Richtung der Probe (1) mit einem Öffnungshalbwinkel von beispielsweise 0,75 rad, der durch die numerische Öffnung der Linse (8) bestimmt wird. Eine hochauflösende Luft- oder Vakuumlinse ermöglicht eine 100-fache Vergrößerung bei einer numerischen Öffnung von 1,0 und einer Arbeitsdistanz von 0,15 mm. Die Linse (8) fokussiert den Lichtstrahl (9) auf die Probe (1), wobei ein breiter Lichtstrahl (9) mit einem Durchmesser von beispielsweise 9 mm am anderen Ende der Linse (8) vorliegt. Die Linse (8) weist einen konischen Hohlraum auf, der entlang der optischen Achse der Linse (8) angeordnet ist und als Elektronendriftraum (6) dient. Die Maße des konischen Hohlraums passen zu dem Strahlengang, der für die STEM-Detektion verwendet wird mit typischen Öffnungshalbwinkeln von 0,050 bis 0,20 rad. Der Durchmesser der Vertiefung an der Oberseite der Linse (8), direkt unter der Probe (1), beträgt beispielsweise 0,060 mm, der um 0,20 rad bei einem Abstand von 0,15 mm abnimmt. Der Hohlraum erstreckt sich durch die Linse (8) mit einem Winkel von 0,2 rad. Bei einer Linse (8) von 10 mm Länge beträgt der Hohlraum an der Unterseite der Linse (8) somit 4,0 mm. Der STEM-Detektor (7) wird an der weitesten Stelle des Hohlraums angeordnet.

Obwohl die Anwesenheit des Hohlraums den Strahlengang durch die Linse (8) beschränkt, reduziert dieser lediglich die Gesamtmenge an Licht, das durch die Linse (8) durchtritt, wobei die Linse (8) immer noch die Fähigkeit hat, den Lichtstrahl auf die Probe (1) zu fokussieren, Licht von der Probe zu sammeln und für die Lichtmikroskopie ein vergrößertes Bild des beleuchteten Bereichs auf einen positionssensitiven Lichtdetektor zu projizieren. Alternativ kann ein konfokales optisches System verwendet werden. Alternativ können auch mehrere zusätzliche lichtoptische Strahlengänge zur Detektion oder Beleuchtung benutzt werden.

Der STEM-Detektor besteht aus einem Zylinder aus Szintillatormaterial von einem Durchmesser von beispielsweise 4,0 mm, um Elektronen in Lichtpulse umzuwandeln. Der Szintillator ist mit einem empfindlichen Lichtdetektor gekoppelt, beispielsweise einer Photovervielfacher-Röhre. Diese Röhre ist seitlich an der Linse angeschlossen. Dazu hat der Szintillator seitlich der optischen Linse eine Anschlussfläche. Die Außenseite ist mit reflektierendem und leicht abgestuftem Material versehen, so dass das Licht aus dem lichtoptischen Strahlengang nicht in den STEM-Detektor (7) eingekoppelt wird. Der STEM-Detektor (7) kann auch aus einem kleinen Mikrochip mit einem ladungsgekoppelten Elementdetektor bestehen. Der Mittelkreis des STEM-Detektors (7) mit einem entsprechenden Halbwinkel von 50 mrad ist von der Detektion entkoppelt, beispielsweise blockiert oder das Signal aus diesem Bereich wird als sekundäres Detektionssignal verwendet. So registriert der STEM-Detektor (7) Signale von übermittelten Elektronen mit Halbwinkeln von 50 mrad bis 0,20 rad. Das Signal wird als Dunkelfeldsignal bezeichnet.

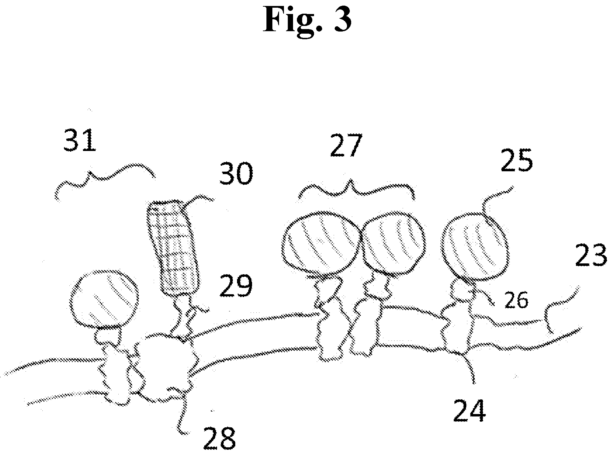

Fig. 3 gibt eine schematische Darstellung einer zellulären Plasmamembran wieder, bestehend aus einer Doppellipidschicht (23) mit Membranproteinen (24). Die Oberseite stellt die Außenseite der Zelle dar. Ein Antikörperfragment (26) ist an das Membranprotein gebunden und ein Gold-Nanopartikel (25) ist mit einem Antikörper-Fragment adhäriert. Die Membran besitzt auch ein Paar des gleichen Proteins (Dimer) mit zwei Goldnanopartikeln (27). Eine andere Art von Membranprotein (28) ist mit einem anderen Antikörper (29) verbunden und mit einem Gold-Nanopartikel, aufweisend eine andere Form (30), markiert. Das aus zwei verschiedenen Proteinen gebildete Paar (31) kann aufgrund der Nähe der zwei verschiedenen Markierungen detektiert werden.

## Patentansprüche

1. Vorrichtung für die stöchiometrische Analyse von Proben (1), umfassend
a) eine Probenverarbeitungsvorrichtung, umfassend eine Probenhalterung (15) zum Halten der Probe (1), Mittel zum Einstellen der Temperatur, Mittel zum Hinzufügen und Entfernen von Fluiden (16, 17, 18, 19, 21, 22) sowie mindestens ein Fluidreservoir (20),
b) ein Elektronenmikroskop mit einem STEM-Detektor und ein Lichtmikroskop, sowie
c) eine durch einen Computer gesteuerte und automatisierte Bildaufnahmevorrichtung, welche mittels des Elektronenmikroskops oder Lichtmikroskops Bilder aufnimmt, eine die aufgenommenen Bilder speichernde Einheit, sowie eine durch den Computer gesteuerte Bildanalyseeinheit,
**dadurch gekennzeichnet, dass** die Vorrichtung eine durch einen Computer gesteuerte Prozesssteuerungseinrichtung zum Steuern der Mittel zum Einstellen der Temperatur und der Mittel zum Hinzufügen und Entfernen von Fluiden (16, 17, 18, 19, 21, 22) umfasst, und das Lichtmikroskop eine lichtoptische Linse (8), die einen Hohlraum (5) aufweist, umfasst.

2. Vorrichtung für die stöchiometrische Analyse von Proben (1) gemäß Anspruch I, **dadurch gekennzeichnet, dass** die Probenhalterung (15) in einer Kavität (14) angeordnet ist.

3. Vorrichtung für die stöchiometrische Analyse von Proben (1) gemäß Anspruch 1, **dadurch gekennzeichnet, dass** die Probenhalterung (15) als dünne elektronendurchlässige Membran (2) ausgebildet ist.

4. Vorrichtung für die stöchiometrische Analyse von Proben (1) gemäß Anspruch 2 oder Anspruch 3, **dadurch gekennzeichnet, dass** die Proben (1) in einer Flüssigkeit (12) auf der Probenhalterung aufgebracht und mit einem Deckel, der ein elektronendurchlässiges Fenster umfasst, abgedeckt sind.

5. Vorrichtung für die stöchiometrische Analyse von Proben (1) gemäß Anspruch 1 , **dadurch gekennzeichnet, dass** die Probenverarbeitungsvorrichtung einen dreidimensional beweglichen Objekttisch aufweist.

6. Vorrichtung für die stöchiometrische Analyse von Proben (1) gemäß Anspruch 1, **dadurch gekennzeichnet, dass** das Elektronenmikroskop ein Rasterelektronenmikroskop (SEM) ist.

7. Vorrichtung für die stöchiometrische Analyse von Proben (1) gemäß Anspruch 1, **dadurch gekennzeichnet, dass** das Elektronenmikroskop ein Transmissionselektronenmikroskop (TEM) ist.

8. Vorrichtung für die stöchiometrische Analyse von Proben (1) gemäß einem der Ansprüche I bis 7, **dadurch gekennzeichnet, dass** in dem Hohlraum (5) der lichtoptischen Linse (8) der STEM-Detektor (7 ) angeordnet ist.

9. Vorrichtung für die stöchiometrische Analyse von Proben (1) gemäß Anspruch 8, **dadurch gekennzeichnet, dass** der Hohlraum (5) probenseitig eine Öffnung mit geringem Durchmesser aufweist, an die sich ein Elektronendriftraum (6) anschließt, an dessen unteren Ende der STEM-Detektor (7) angeordnet ist.

10. Vorrichtung für die stöchiometrische Analyse von Proben (1) gemäß Anspruch 2, **dadurch gekennzeichnet, dass** ein Vakuum in der Kavität (14) einstellbar ist.

11. Vorrichtung für die stöchiometrische Analyse von Proben (1) gemäß Anspruch 9, **dadurch gekennzeichnet, dass** ein Vakuum in dem Elektronendriftraum (6) einstellbar ist.

12. Vorrichtung für die stöchiometrische Analyse von Proben (1) gemäß einem der Ansprüche 1 bis 11, **dadurch gekennzeichnet, dass** die Vorrichtung für Proben (1) geeignet ist, die biologische Zellen, bevorzugt eukaryotische Zellen, sind.

13. Vorrichtung für die stöchiometrische Analyse von Proben (1) gemäß einem der Ansprüche 1 bis 11, **dadurch gekennzeichnet, dass** die Vorrichtung für Proben (1) geeignet ist, die biologische Moleküle, Nanopartikel, Polymere oder keramische oder metallische Mikrostrukturen sind.

14. Vorrichtung für die stöchiometrische Analyse von Proben (1) gemäß Anspruch 3, **dadurch gekennzeichnet, dass** die dünne elektronendurchlässige Membran (2) durch einen Mikrochip und/oder ein Gitter gestützt ist.

15. Vorrichtung für die stöchiometrische Analyse von Proben (1) gemäß Anspruch 3 oder Anspruch 14, **dadurch gekennzeichnet, dass** die dünne elektronendurchlässige Membran (2) aus Siliziumnitrid, Siliziumoxid besteht oder mit einer Kohlenstoffschicht beschichtet ist.

16. Verfahren für die stöchiometrische Analyse von Proben (1) unter Verwendung einer Vorrichtung gemäß Anspruch 1, umfassend die Schritte:
a) Aufbringen der Probe auf die Probenhalterung,
b) Probenverarbeitung mittels der Probenverarbeitungsvorrichtung,
c) Aufnahme einer Serie von Elektronenmikroskopie-Bildern,
d) Speicherung der einzelnen Elektronenmikroskopie-Bilder in der die Bilder speichernden Einheit,
e) Auswertung der Elektronenmikroskopie-Bilder,
wobei bei dem Verfahren zusätzlich lichtmikroskopische Bilder aufgenommen werden.

17. Verfahren für die stöchiometrische Analyse von Proben (1) gemäß Anspruch 16, **dadurch gekennzeichnet, dass** Elektronenmikroskopie-Bilder und lichtmikroskopische Aufnahmen miteinander korreliert werden.

18. Verfahren für die stöchiometrische Analyse von Proben (1) gemäß Anspruch 16, **dadurch gekennzeichnet, dass** ein oder mehrere Schritte der Schritte b) bis e) des Verfahrens wiederholt werden.

19. Verfahren für die stöchiometrische Analyse von Proben (1) gemäß Anspruch 16, **dadurch gekennzeichnet, dass** im Schritt b) spezifische Markierungen, insbesondere Nanopartikel (25; 27; 30), die spezifisch an Proteinen anbinden, der Probe (1) zugeführt werden.

## Claims

1. Device for the stoichiometric analysis of samples (1) comprising
a) a sample processing device comprising a sample holder (15) for holding the sample (1), means for setting the temperature, means for adding and removing fluids (16, 17, 18, 19, 21, 22) and at least one fluid reservoir (20),
b) an electron microscope with a STEM detector and a light microscope, and
c) a computer-controlled and automated imaging device that captures images by means of the electron microscope or light microscope, a unit that stores the captured images and an image analysis unit controlled by the computer,
**characterized in that,** the device comprises a computer-controlled process control system for controlling the means for setting the temperature and the means for adding and removing fluids (16, 17, 18, 19, 21, 22), and the light microscope comprises a photo-optical lens (8) with a cavity (5).

2. Device for the stoichiometric analysis of samples (1) according to claim 1, **characterized in that,** the sample holder (15) is disposed in a well (14).

3. Device for the stoichiometric analysis of samples (1) according to claim 1, **characterized in that,** the sample holder (15) is configured as a thin, electron-permeable membrane (2).

4. Device for the stoichiometric analysis of samples (1) according to claim 2, **characterized in that,** the samples (1) are applied to the sample holder in a liquid (12) and are covered with a lid that has an electron-permeable window.

5. Device for the stoichiometric analysis of samples (1) according to claim 1, **characterized in that,** the sample processing device has a three-dimensional, movable microscope stage.

6. Device for the stoichiometric analysis of samples (1) according to claim 1, **characterized in that,** the electron microscope is a scanning electron microscope (SEM).

7. Device for the stoichiometric analysis of samples (1) according to claim 1, **characterized in that,** the electron microscope is a transmission electron microscope (TEM).

8. Device for the stoichiometric analysis of samples (1) according to one of the claims 1 to 7, **characterized in that,** the STEM detector (7) is positioned in the cavity (5) of the photo-optical lens (8)

9. Device for the stoichiometric analysis of samples (1) according to claim 8, **characterized in that,** the cavity (5) has, at the sample end, a small-diameter opening followed by an electron drift chamber (6) at the lower end of which the STEM detector (7) is located.

10. Device for the stoichiometric analysis of samples (1) according to claim 2, **characterized in that** a vacuum can be established in the well (14).

11. Device for the stoichiometric analysis of samples (1) according to claim 9, **characterized in that** a vacuum can be established in the drift chamber (6).

12. Device for the stoichiometric analysis of samples (1) according to one of the claims 1 to 11, **characterized in that** the device is suitable for samples, which are biological cells, preferably eukaryotic cells.

13. Device for the stoichiometric analysis of samples (1) according to one of the claims 1 to 11, **characterized in that** the device is suitable for samples, which are biological molecules, nanoparticles, polymers or ceramic or metallic microstructures.

14. Device for the stoichiometric analysis of samples (1) according to claim 3, **characterized in that** the thin, electron-permeable membrane (2) is supported by a microchip and/or a grid.

15. Device for the stoichiometric analysis of samples (1) according to claim 3 or claim 14, **characterized in that** the thin, electron-permeable membrane (2) comprises silicon nitride or silicon oxide or is coated with carbon.

16. Method for the stoichiometric analysis of samples (1) using a device according to claim 1, comprising the steps of:
a) Applying the sample to the sample holder,
b) Processing the sample with the sample processing device,
c) Capturing a series of electron-microscopy images,
d) Storing the individual electron-microscopy images in the image-storing unit,
e) Evaluating the electron-microscopy images,
wherein in the process light-microscopy images are captured in addition.

17. Method for the stoichiometric analysis of samples (1) according to claim 16, **characterized in that,** electron-microscopy images and light-microscopy images are correlated with each other.

18. Method for the stoichiometric analysis of samples (1) according to claim 16, **characterized in that,** one or more of the steps b) to e) of the method are repeated.

19. Method for the stoichiometric analysis of samples (1) according to claim 16, **characterized in that,** specific markers, in particular nanoparticles (25; 27; 30) that bind specifically to proteins, are supplied to the sample (1) in step b) of the method.

## Revendications

1. Dispositif d'analyse stœchiométrique d'échantillons (1), ledit dispositif comprenant
a) un dispositif de traitement d'échantillon comprenant un porte-échantillon (15) destiné à supporter l'échantillon (1), des moyens de réglage de la température, des moyens d'ajout et de retrait de fluides (16, 17, 18, 19, 21, 22) et au moins un réservoir de fluide (20),
b) un microscope électronique comprenant un détecteur STEM et un microscope optique, ainsi que
c) un dispositif de capture d'images qui est automatisé et commandé par un ordinateur et qui capture des images au moyen du microscope électronique ou du microscope optique, une unité de mémorisation des images capturées, et une unité d'analyse d'images commandée par l'ordinateur,
**caractérisé en ce que** le dispositif comprend un organe de commande de processus commandé par un ordinateur et destiné à commander les moyens de réglage de la température et les moyens d'ajout et de retrait de fluides (16, 17, 18, 19, 21, 22), et le microscope optique comporte une lentille optique (8) qui comporte une cavité (5).

2. Dispositif d'analyse stœchiométrique d'échantillons (1) selon la revendication 1, **caractérisé en ce que** le porte-échantillon (15) est disposé dans une cavité (14).

3. Dispositif d'analyse stœchiométrique d'échantillons (1) selon la revendication 1, **caractérisé en ce que** le porte-échantillon (15) est conçu sous la forme d'une fine membrane (2) perméable aux électrons.

4. Dispositif d'analyse stœchiométrique d'échantillons (1) selon la revendication 2 ou la revendication 3, **caractérisé en ce que** les échantillons (1) sont appliqués dans un liquide (12) sur le porte-échantillon et sont recouverts d'un couvercle qui comprend une fenêtre perméable aux électrons.

5. Dispositif d'analyse stœchiométrique d'échantillons (1) selon la revendication 1, **caractérisé en ce que** le dispositif de traitement d'échantillons comporte une table d'objet mobile dans trois dimensions.

6. Dispositif d'analyse stœchiométrique d'échantillons (1) selon la revendication 1, **caractérisé en ce que** le microscope électronique est un microscope électronique à balayage (MEB).

7. Dispositif d'analyse stœchiométrique d'échantillons (1) selon la revendication 1, **caractérisé en ce que** le microscope électronique est un microscope électronique à transmission (MET).

8. Dispositif d'analyse stœchiométrique d'échantillons (1) selon l'une des revendications 1 à 7, **caractérisé en ce que** le détecteur STEM (7) est disposé dans la cavité (5) de la lentille optique (8).

9. Dispositif d'analyse stœchiométrique d'échantillons (1) selon la revendication 8, **caractérisé en ce que** la cavité (5) comporte côté échantillon une ouverture de faible diamètre qui est suivie d'un espace de dérive électronique (6) à l'extrémité inférieure de laquelle le détecteur STEM (7) est disposé.

10. Dispositif d'analyse stœchiométrique d'échantillons (1) selon la revendication 2, **caractérisé en ce qu'**un vide peut être réglé dans la cavité (14).

11. Dispositif d'analyse stœchiométrique d'échantillons (1) selon la revendication 9, **caractérisé en ce qu'**un vide peut être réglé dans l'espace de dérive électronique (6).

12. Dispositif d'analyse stœchiométrique d'échantillons (1) selon l'une des revendications 1 à 11, **caractérisé en ce que** le dispositif est approprié à des échantillons (1) qui sont des cellules biologiques, de préférence des cellules eucaryotes.

13. Dispositif d'analyse stœchiométrique d'échantillons (1) selon l'une des revendications 1 à 11, **caractérisé en ce que** le dispositif est approprié à des échantillons (1) qui sont des molécules biologiques, des nanoparticules, des polymères ou des microstructures céramiques ou métalliques.

14. Dispositif d'analyse stœchiométrique d'échantillons (1) selon la revendication 3, **caractérisé en ce que** la membrane mince (2) perméable aux électrons est supportée par une micro-puce et/ou une grille.

15. Dispositif d'analyse stœchiométrique d'échantillons (1) selon la revendication 3 ou la revendication 14, **caractérisé en ce que** la membrane mince (2) perméable aux électrons comprend du nitrure de silicium, de l'oxyde de silicium ou est revêtue d'une couche de carbone.

16. Procédé d'analyse stœchiométrique d'échantillons (1) à l'aide d'un dispositif selon l'une des revendications précédentes, ledit procédé comprenant les étapes suivantes :
a) appliquer l'échantillon sur le porte-échantillon,
b) traiter les échantillons au moyen du dispositif de traitement d'échantillons,
c) capturer une série d'images de microscopie électronique,
d) mémoriser les images individuelles de microscopie électronique dans l'unité de mémorisation d'images,
e) évaluer les images de microscopie électronique, des images de microscopie optique étant également capturées dans le procédé.

17. Procédé d'analyse stœchiométrique d'échantillons (1) selon la revendication 16, **caractérisé en ce que** les images de microscopie électronique et les images de microscopie optique sont corrélées entre elles.

18. Procédé d'analyse stœchiométrique d'échantillons (1) selon la revendication 16, **caractérisé en ce qu'**une ou plusieurs étapes des étapes b) à e) du procédé sont répétées.

19. Procédé d'analyse stœchiométrique d'échantillons (1) selon la revendication 16, **caractérisé en ce qu'**à l'étape b) des repères spécifiques, notamment des nanoparticules (25 ; 27 ; 30) qui se lient spécifiquement à des protéines, sont fournis à l'échantillon (1).
